(19) Europäisches Patentamt
European Patent Office
Office européen des brevets

(11) **EP 2 323 252 A1**

(12) **DEMANDE DE BREVET EUROPEEN**

(43) Date de publication:
**18.05.2011 Bulletin 2011/20**

(51) Int Cl.:
***H03B 9/14*** *(2006.01)*

(21) Numéro de dépôt: **10189958.1**

(22) Date de dépôt: **04.11.2010**

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**
Etats d'extension désignés:
**BA ME**

(30) Priorité: **06.11.2009 FR 0957888**

(71) Demandeurs:
• **Commissariat à l'Énergie Atomique
et aux Énergies Alternatives
75015 Paris (FR)**

• **Centre National de la Recherche Scientifique
75016 Paris (FR)**

(72) Inventeurs:
• **Delaet, Bertrand
38190 Bernin (FR)**
• **Ebels, Ursula
38100 Grenoble (FR)**

(74) Mandataire: **Colombo, Michel et al
Brevinnov
324, rue Garibaldi
69007 Lyon (FR)**

(54) **Oscillateur radiofréquence à base magnétorésistive**

(57) Cet oscillateur radiofréquence comprend une couche libre (10) et/ou une couche de référence formée par un empilement d'au moins trois sous-couches ferromagnétiques ou ferrimagnétiques couplées les unes aux autres par un couplage RKKY (Ruderman-Kittel-Kasuya-Yosida) et parmi lesquelles au moins deux sous-couches sont couplées magnétiquement l'une à l'autre par un couplage RKKY antiferromagnétique.

**EP 2 323 252 A1**

**Description**

L'invention concerne un oscillateur radiofréquence.

Plus particulièrement, l'invention concerne un oscillateur radiofréquence intégrant un dispositif magnétorésistif au sein duquel circule un courant électrique polarisé en spin. Dans un tel oscillateur, le passage du courant provoque une variation périodique de la résistance du dispositif magnétorésistif. Un signal haute fréquence, c'est-à-dire dont la fréquence est typiquement comprise entre 100 MHz et quelques dizaines de GHz, est construit à partir de cette variation périodique. La période des variations de la résistivité, et donc la fréquence d'oscillation, peut être réglée en jouant sur l'intensité du courant qui traverse le dispositif magnétorésistif et/ ou le champ magnétique externe.

De tels oscillateurs ont par exemple vocation à être utilisés dans le domaine des radiotélécommunications car ils peuvent générer une large gamme de fréquences avec un facteur de qualité élevé.

Par facteur de qualité, on désigne ici le rapport suivant :

$$Q = f/\Delta f$$

où :

- Q est le facteur de qualité,
- f est la fréquence d'oscillation de l'oscillateur, et
- $\Delta f$ est la largeur à mi-hauteur de la raie centrée sur la fréquence f dans le spectre de puissance de cet oscillateur.

Certains oscillateurs radiofréquences sont issus de l'électronique de spin.

L'électronique de spin utilise le spin des électrons comme degré de liberté supplémentaire afin de générer des effets nouveaux. La polarisation en spin d'un courant électrique résulte de l'asymétrie existant entre la diffusion des électrons de conduction de type "spin-up" (c'est-à-dire parallèle à l'aimantation locale) et de type "spin-down" (c'est-à-dire anti-parallèle à l'aimantation locale). Cette asymétrie conduit à une asymétrie de la conductivité entre les deux canaux de spin-up et down, d'où une polarisation de spin nette du courant électrique.

Cette polarisation en spin du courant est à l'origine de phénomènes magnétorésistifs dans les multicouches magnétiques tels que la magnétorésistance géante (Baibich, M., Broto, J.M., Fert, A., Nguyen Van Dau, F., Petroff, F., Etienne, P., Creuzet, G., Friederch, A. and Chazelas, J., " Giant magnetoresistance of (001) Fe/(001)Cr magnetic superlattices ", Phys.Rev.Lett., 61 (1988) 2472), ou la magnétorésistance tunnel (Moodera, JS., Kinder, LR., Wong, TM. and Meservey,R.. "Large magnetoresistance at room temperature in ferromagnetic thin film tunnel junctions", Phys.Rev.Lett 74 , (1995) 3273-6).

Par ailleurs, il a également été observé qu'en faisant passer un courant polarisé en spin à travers une couche mince magnétique, on pouvait induire un renversement de son aimantation en l'absence de tout champ magnétique externe (Katine, J.A., Albert, F.J., Buhrman, R.A., Myers, E.B., and Ralph, D.C., "Current-Driven Magnetization Reversal and Spin-Wave Excitations in Co /Cu /Co Pillars ", Phys.Rev.Lett. 84, 3149 (2000).).

Le courant polarisé peut également générer des excitations magnétiques entretenues, également dénommées oscillations (Kiselev, S.I., Sankey, J.C., Krivorotov, LN., Emley, N.C., Schoelkopf, R.J., Buhrman, R.A., and Ralph, D.C., "Microwave oscillations of a nanomagnet driven by a spin-polarized current", Nature, 425, 380 (2003)). L'utilisation de l'effet de génération d'excitations magnétiques entretenues dans un dispositif magnétorésistif permet de convertir cet effet en une modulation de résistance électrique directement utilisable dans les circuits électroniques, et donc corollairement, susceptible d'intervenir directement au niveau de la fréquence. Le document US 5 695 864 décrit divers développements mettant en oeuvre le principe physique mentionné précédemment. Il décrit notamment la précession de l'aimantation d'une couche magnétique traversée par un courant électrique polarisé en spin. Les principes physiques mis en oeuvre ainsi que la terminologie utilisée sont également décrits et définis dans la demande de brevet FR 2 892 871.

La fréquence d'oscillation de ces oscillateurs radiofréquences est ajustée en jouant sur l'intensité du courant qui le traverse et, éventuellement en plus, sur un champ magnétique externe.

Il est connu de la demande FR 2 892 871 un oscillateur radiofréquence comprenant un empilement d'au moins :

- une première couche magnétique, dite « couche de référence », apte à polariser en spin le courant électrique et dont l'aimantation est de direction fixe,
- une seconde couche magnétique, dite « couche libre », dont l'aimantation peut osciller lorsqu'elle est traversée par le courant polarisé en spin,
- une couche non magnétique, dite « espaceur », interposée entre les deux couches précédentes et destinée à découpler magnétiquement lesdites première et seconde couches magnétiques, et
- des moyens pour faire circuler un courant d'électrons dans lesdites couches perpendiculairement à celles-ci.

La demande FR 2 892 871 enseigne que pour améliorer la cohérence de précession il est avantageux de réaliser la couche libre à l'aide d'un empilement de sous-couches ferromagnétiques constituant un antiferromagnétique synthétique.

Par cohérence de la précession, on désigne le fait que l'aimantation est mise en mouvement comme un seul bloc sur toute l'extension de la nappe de courant traversant la structure (c'est-à-dire sur la section du pilier dans la géométrie de pilier et sur la section du cône de courant au niveau de la couche libre dans le cas de la géométrie de nanocontact), par opposition à la génération de multiples petites excitations incohérentes entre elles.

On désigne par antiferromagnétique synthétique ou artificiel, également connu sous l'acronyme SAF (synthetic antiferromagnetic), un empilement d'au moins deux sous-couches ferromagnétiques, chaque couche étant couplée magnétiquement avec chaque sous-couche ferromagnétique adjacente par un couplage RKKY (Ruderman-Kittel-Kasuya-Yosida) antiferromagnétique. De plus, les sous-couches ferromagnétiques d'un antiferromagnétique synthétique sont dimensionnées pour que l'aimantation globale de l'antiferromagnétique synthétique soit nulle en absence de champ magnétique extérieur.

Pour obtenir un couplage RKKY, les sous-couches ferromagnétiques sont séparées les unes des autres par de fines sous-couches non magnétiques.

Selon l'épaisseur de la sous-couche non magnétique, le couplage RKKY obtenu est :

- soit « antiferromagnétique », c'est-à-dire que les moments magnétiques des deux sous-couches couplées sont antiparallèles,
- soit « ferromagnétique », c'est-à-dire que les moments magnétiques des deux sous-couches couplées sont parallèles.

Dans un antiferromagnétique synthétique, l'épaisseur de la ou des sous-couches non magnétiques est systématiquement choisie pour obtenir un couplage RKKY antiferromagnétique.

Pour plus d'informations sur le couplage RKKY, il est possible de se référer aux deux articles suivants : S. Parkin et al., Physical Review B 44 N°13 (1991) et S. Parkin et al. Physical Review Letters 64 N°19 (1990)

Pour obtenir une aimantation globalement nulle, les moments magnétiques de chaque sous-couche ferromagnétique se compensent mutuellement. Par exemple, dans le cas d'un antiferromagnétique synthétique à deux sous-couches ferromagnétiques, la relation suivante est vérifiée :

$$(M1*t1 - M2*t2)/(t1+t2) = 0$$

où :

- M1 et t1 sont, respectivement, le moment magnétique et l'épaisseur de la première couche magnétique, et

- M2 et t2 sont, respectivement, le moment magnétique et l'épaisseur de la seconde couche magnétique.

Un antiferromagnetique synthétique est un ferrimagnétique synthétique particulier. Les ferrimagnétique synthétiques sont connus sous l'acronyme SYF (Synthetical Ferrimagnetic). Un ferrimagnétique synthétique est un empilement d'au moins deux sous-couches ferromagnétiques ou ferrimagnétiques, couplées l'une à l'autre au travers d'une couche non magnétique par un couplage RKKY antiferromagnétique. Contrairement à l'antiferromagnétique synthétique, l'aimantation résultante de cet empilement n'est pas forcément nulle.

Par couche ou matériau non magnétique, on désigne une couche ou un matériau qui ne présente pas d'aimantation mesurable en champ nul. Il peut donc s'agir de matériau ne présentant aucune propriété magnétique, d'un matériau amagnétique ou d'un matériau diamagnétique ou d'un matériau paramagnétique.

La demande de brevet FR 2 892 871 décrit l'utilisation d'un antiferromagnétique synthétique pour former la couche libre de l'oscillateur radiofréquence. Cet antiferromagnétique synthétique se compose uniquement de deux sous-couches ferromagnétiques.

L'invention vise à proposer un oscillateur radiofréquence ayant un facteur de qualité amélioré. Elle a donc pour objet un oscillateur radiofréquence dans lequel la couche libre et/ou la couche de référence est formée d'un empilement d'au moins trois sous-couches ferromagnétiques ou ferrimagnétiques couplées les unes aux autres par couplage RKKY (Ruderman-Kittel-Kasuya-Yosida) et parmi lesquelles au moins deux sous-couches sont couplées magnétiquement l'une à l'autre par un couplage RKKY antiferromagnétique.

Il a été constaté que la largeur de raie $\Delta f$ de l'oscillateur radiofréquence à la fréquence d'oscillation f est inversement proportionnelle au volume (appelé par la suite volume efficace et noté $V_{eff}$) du matériau magnétique de la couche libre ou de la couche de référence. La réalisation de la couche libre ou de la couche de référence à l'aide d'un empilement d'au moins trois sous-couches ferromagnétiques ou ferrimagnétiques couplées magnétiquement les unes aux autres par couplage RKKY permet d'augmenter le volume efficace de cette couche.

En effet, le volume efficace de la couche libre ou de référence correspond à la somme des volumes de chaque sous-couche ferromagnétique ou ferrimagnétique qui la compose. Cet accroissement du volume efficace décroît la largeur de raie $\Delta f$ et améliore donc le facteur de qualité de cet oscillateur.

De plus, grâce à la réalisation de la couche libre ou de référence sous la forme d'un empilement de sous-couches couplées magnétiquement par couplage RKKY, la diminution de la largeur de raie $\Delta f$ se produit :

- sans pour autant dégrader, et même en améliorant, la cohérence de précession entretenue dans cette couche, et

- sans changer, et même en diminuant, l'intensité du courant critique $I_c$ nécessaire pour déclencher les oscillations entretenues de l'oscillateur.

Les modes de réalisation de cet oscillateur radiofréquence peuvent également comporter une ou plusieurs des caractéristiques suivantes :

■ chaque sous-couches ferromagnétique ou ferrimagnétique de l'empilement est couplée à la sous-couche ferromagnétique ou ferrimagnétique placée immédiatement au-dessus par un couplage RKKY antiferromagnétique de manière à ce que l'empilement constitue un ferrimagnétique synthétique;

■ dans lequel les sous-couches sont des sous-couches ferromagnétiques et les moments magnétiques de chaque sous-couche ferromagnétique se compensent mutuellement de manière à ce que l'empilement constitue un antiferromagnetique synthétique;

■ au moins deux sous-couches ferromagnétiques ou ferrimagnétiques sont couplées l'une à l'autre par un couplage RKKY antiferromagnétique et au moins deux sous-couches ferromagnétiques ou ferrimagnétiques sont couplées l'une à l'autre par un couplage RKKY ferromagnétique;

■ l'empilement de sous-couches ferromagnétiques ou ferrimagnétiques se compose uniquement de trois sous-couches ferromagnétiques ou ferrimagnétiques;

■ l'épaisseur d'une première sous-couche ferromagnétique ou ferrimagnétique, la plus proche de la couche non magnétique, est inférieure à 10 nm et avantageusement comprise entre 1 et 4 nm;

■ au moins la couche libre est formée par l'empilement d'au moins trois sous-couches ferromagnétiques couplées les unes aux autres par un couplage RKKY (Ruderman-Kittel-Kasuya-Yosida);

■ l'oscillateur comporte une couche antiferromagnétique directement en contact avec la couche de référence pour piéger son aimantation, et

■ la couche de référence est un antiferromagnétique synthétique.

Ces modes de réalisation de l'oscillateur radiofréquence présentent en outre les avantages suivants :

- utiliser un empilement dont le moment magnétique global est sensiblement nul accroît la stabilité de l'oscillateur par réduction voire par suppression du champ dipolaire rayonné sur les autres couches magnétiques,
- le fait que l'épaisseur de la première sous-couche ferromagnétique soit inférieure à 4 nm permet de diminuer l'intensité du courant critique $I_c$. En effet ce courant est directement proportionnel à l'épaisseur de la première couche, et

- piéger la couche de référence avec une couche antiferromagnétique ou réaliser la couche de référence à l'aide d'un antiférromagnétique synthétique permet d'accroître la stabilité de l'aimantation de la couche de référence.

L'invention sera mieux comprise à la lecture de la description qui va suivre donnée uniquement à titre d'exemple non limitatif et faite en se référant aux dessins sur lesquels :

- la figure 1 est une illustration schématique d'un oscillateur radiofréquence,
- les figures 2 à 5 sont des illustrations schématiques d'autres modes de réalisation de l'oscillateur radiofréquence de la figure 1,
- la figure 6 est une illustration schématique d'un antiferromagnétique synthétique susceptible d'être mis en oeuvre pour réaliser l'un quelconque des oscillateurs des figures 1 à 5, et
- la figure 7 est une illustration schématique d'un empilement de sous-couches ferromagnétiques susceptible d'être mis en oeuvre pour réaliser l'un quelconque des oscillateurs des figures 1 à 5.

Dans ces figures, les mêmes références sont utilisées pour désigner les mêmes éléments.

Dans la suite de cette description, les caractéristiques et fonctions bien connues de l'homme du métier ne sont pas décrites en détail.

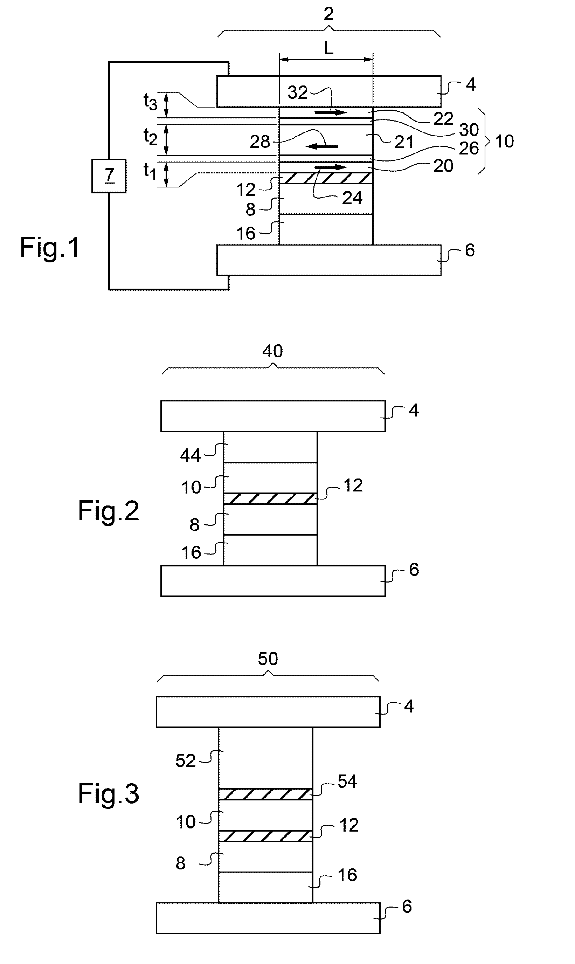

La figure 1 représente un oscillateur radiofréquence 2. Cet oscillateur 2 intègre un dispositif magnétorésistif au sein duquel circule un courant électrique polarisé en spin. Ce dispositif magnétorésistif est conformé selon une géométrie connue sous l'acronyme CPP (« current perpendicular to plane »). Plus précisément, sur la figure 1, le dispositif magnétorésistif adopte une structure connue sous le terme de « nanopilier ». Ce nanopilier est un pilier formé en empilant les unes au-dessus des autres des couches horizontales de même section horizontale.

De plus, l'oscillateur 2 comprend à chaque extrémité du pilier une électrode conductrice, respectivement, 4 et 6. Ces électrodes permettent d'amener le courant qui traverse les différentes couches formant le dispositif magnétorésistif perpendiculairement au plan de ces couches. Lorsque l'intensité de ce courant dépasse l'intensité du courant critique $I_c$, la tension entre ces électrodes 4 et 6 se met à osciller à une fréquence qui est fonction du courant qui traverse les électrodes. Par exemple, cette tension est transmise à un équipement électronique 7 qui la traite pour, par exemple, créer un signal de référence.

Entre ces électrodes 4 et 6, le pilier comprend principalement trois couches à savoir une couche de référence 8, une couche libre 10 et une couche 12 non magnétique interposée entre les couches 8 et 10. La couche non magnétique est plus connue sous le terme d' « espaceur » ou « spacer » en anglais.

Ces couches 8, 10 et 12 sont agencées et conformées de manière à permettre l'apparition des propriétés magnétoresistives, c'est-à-dire une variation de la résistance du pilier en fonction des directions d'aimantation des couches 8 et 10.

La largeur L des différentes couches qui composent le pilier est constante. Ici, la largeur L est inférieure à 1 $\mu$m et, typiquement, comprise entre 20 nm et 200 nm.

La couche de référence 8 est réalisée dans un matériau magnétique électriquement conducteur. Sa face supérieure est directement en contact avec l'espaceur 12. Elle présente une direction de plus facile aimantation comprise dans le plan de la couche.

La couche de référence 8 a pour fonction de polariser en spin les électrons du courant qui la traverse. Elle présente donc une épaisseur suffisante pour réaliser cette fonction. Typiquement, l'épaisseur de la couche de référence 8 est strictement supérieure à la longueur de diffusion de spin (voir par exemple la demande de brevet FR2892871 pour une définition de ce terme).

Par exemple, la couche de référence 8 est réalisée en cobalt (Co), Nickel (Ni), Fer(Fe) ou leur alliage (CoFe, NiFe, CoFeB ...etc.). L'épaisseur de la couche de référence 8 est de l'ordre de quelques nanomètres. La couche de référence 8 peut être laminée par insertion de quelques (typiquement de 2 à 4) très fines couches de cuivre, d'argent ou d'or d'épaisseur de l'ordre de 0,2 à 0,5 nm pour réduire la longueur de diffusion de spin. Il est possible également que la couche 8 soit un SyF voire un SAF. Pour améliorer la lisibilité de la figure 1, la proportionnalité entre l'épaisseur des différentes couches n'a pas été préservée.

Ici, la couche de référence 8 présente une aimantation dont la direction est fixe. Par aimantation de direction fixe, on désigne le fait que la direction du moment magnétique de la couche de référence 8 est plus difficile à modifier que la direction du moment magnétique de la couche libre 10. Pour obtenir cela, l'aimantation de la couche de référence 8 est par exemple piégée par une couche antiferromagnétique conductrice 16 interposée entre la couche de référence 8 et l'électrode 6. La face supérieure de la couche 16 est par exemple directement en contact avec la face inférieure de la couche de référence 8.

Typiquement, l'épaisseur de la couche 16 est comprise entre 5 et 50 nm. Elle peut être réalisée dans un alliage de manganèse tel que l'un des alliages suivants IrMn, PtMn, FeMn, ... etc. Par exemple, cette couche 16 est réalisée en un matériau choisi dans le groupe comprenant l'IrMn, le FeMn, le PtMn, NiMn.

L'espaceur 12 est une couche non magnétique. Cet espaceur 12 est suffisamment fin pour permettre au courant polarisé en spin de passer de la couche de référence 8 à la couche libre 10 en limitant la perte de polarisation. A l'inverse, l'épaisseur de cet espaceur 12 est suffisamment grande pour assurer le découplage magnétique entre les couches 8 et 10.

Par exemple, l'espaceur 12 est réalisé dans un matériau électriquement conducteur tel que le cuivre (Cu). Les propriétés magnétorésistives du pilier sont alors qualifiées de magnétorésistance géante ou GMR (Geant Magnetoresistance). Dans ce cas, l'épaisseur de l'espaceur 12 est typiquement supérieure à 2 nm. Généralement, son épaisseur est comprise entre 2 et 40 nm et, de préférence, égale à 5 nm à $\pm$25 % près.

L'espaceur 12 peut également être réalisé dans un matériau isolant tel qu'un oxyde ou un nitrure d'aluminium, un oxyde de magnésium, du nitrure de tantale, du titanate de strontium ($SrTiO_3$), ... etc. Le pilier présente alors des propriétés magnétorésistives tunnel ou TMR (Tunnel Magnetoresistance). Dans ce cas, l'épaisseur de l'espaceur 12 est typiquement comprise entre 0,5 nm et 3 nm.

La couche libre 10 est une couche magnétique électriquement conductrice dont l'aimantation peut plus facilement tourner ou « précesser » que celle de la couche de référence 8.

Ici, cette couche libre 10 est réalisée par l'empilement de trois sous-couches ferromagnétiques 20 à 21. Les sous-couches 20, 21 et 21, 22 sont couplées l'une à l'autre par un couplage RKKY antiferromagnétique. L'empilement des sous-couches 20 à 22 constitue donc un ferrimagnétique synthétique. La direction de plus facile aimantation de ces sous-couches est comprise dans le plan des sous-couches.

La face inférieure de la sous-couche 20 est directement en contact avec la face supérieure de l'espaceur 12. L'épaisseur $t_1$ de la sous-couche 20 est aussi petite que possible. En effet, plus cette épaisseur $t_1$ est réduite plus le courant critique $I_c$ est petit. Par exemple, l'épaisseur $t_1$ est comprise entre 1 nm et 6 nm et de préférence comprise entre 1 nm et 4 nm.

Cette sous-couche 20 est réalisée dans un matériau ferromagnétique tel que du cobalt, du nickel ou du fer ou dans un alliage de ces différents métaux (par exemple CoFe, CoFeB, NiFe... etc.).

En absence de courant polarisé en spin ou de champ magnétique extérieur, le moment magnétique global de la sous-couche 20 est orienté parallèlement au plan de cette sous-couche. La direction de ce moment magnétique est représentée par une flèche 24 sur la figure 1.

L'amplitude du moment magnétique de la sous-couche 20 est proportionnelle à l'aimantation $M_1$ du matériau ferromagnétique utilisé pour cette sous-couche multipliée par l'épaisseur $t_1$. La sous-couche 20 occupe un volume $V_1$. Le moment magnétique m est égal au produit de l'aimantation $M_1$ par ce volume $V_1$ et donc proportionnel au produit $M_1*t_1$.

Pour obtenir un couplage RKKY entre les sous-couches 20 et 21, une sous-couche 26 conductrice non magnétique est directement interposée entre ces deux sous-couches 20 et 21. L'épaisseur de cette sous-couche 26 est suffisamment fine pour que les sous-couches ferromagnétiques 20 et 21 soient couplées antiferromagnétiquement. Par couplage antiferromagnétique on indique que les moments magnétiques des sous-couches 20 et 21 sont antiparallèles.

Par exemple, la sous-couche 26 est réalisée dans un matériau tel que du ruthénium (Ru), du rhénium (Re), du cuivre (Cu), du chrome (Cr), du platine (Pt) ou de l'argent (Ag). Selon le matériau choisi pour réaliser la sous-couche 26, son épaisseur pour obtenir un couplage RKKY n'est pas la même. Par exemple, si la sous-couche 26 est en chrome, l'épaisseur est inférieure ou égale à 4,5 nm. Si la sous-couche 26 est en cuivre, l'épaisseur est inférieure à 1,5 nm.

De préférence, l'épaisseur de la sous-couche 26 est de quelques angströms, c'est-à-dire comprise entre 1 et 50 angströms. Par exemple, l'épaisseur est ici de 8 angströms.

La face inférieure de la sous-couche 21 est directement déposée sur la sous-couche 26. Cette sous-couche 21 est couplée magnétiquement par un couplage RKKY antiferromagnétique à la fois aux sous-couches 20 et 22. La direction de son moment magnétique, représentée par une flèche 28, est donc opposée à celle du moment magnétique des sous-couches 20 et 22.

Dans cet exemple de réalisation, l'épaisseur $t_2$ de la sous-couche 21 est choisie strictement supérieure à l'épaisseur $t_1$ de manière à augmenter encore plus le volume efficace $V_{eff}$ de la couche libre 10. En effet, plus le volume efficace $V_{eff}$ de la couche libre 10 augmente plus la largeur de raie $\Delta f$ diminue. Par exemple, l'épaisseur $t_2$ est choisie de manière à ce que le volume $V_2$ de la sous-couche 21 soit au moins supérieur de 10 voire 25 % au volume $V_1$ de la sous-couche 20.

De plus, ici, la sous-couche 21 est conçue pour annuler les moments magnétiques des sous-couches 20 et 22 de manière à réaliser un antiferromagnétique synthétique. L'utilisation d'un antiferromagnétique synthétique compensé pour réaliser la couche libre 10 permet d'augmenter la stabilité de l'oscillateur par réduction du champ dipolaire rayonné sur les autres couches magnétiques.

Dans le cas particulier décrit ici, la sous-couche 21 est réalisée dans le même matériau ferromagnétique que les sous-couches 20 et 22. Son moment magnétique est donc proportionnel à l'aimantation $M_1$ multipliée par l'épaisseur $t_2$. Dès lors, pour annuler les moments magnétiques des sous-couches 20 et 22, l'épaisseur $t_2$ est choisie égale au double de l'épaisseur $t_1$.

Une sous-couche 30 non magnétique conductrice est interposée entre les sous-couches 21 et 22 de manière à obtenir le couplage RKKY antiferromagnétique entre ces sous-couches. Par exemple, cette sous-couche 30 est identique à la sous-couche 26.

La face inférieure de la sous-couche 22 est directement en contact avec la face supérieure de la sous-couche 30. La sous-couche 22 est par exemple identique à la sous-couche 20. La direction de son moment magnétique est ici représentée par une flèche 32.

La figure 2 représente un oscillateur radiofréquence 40 identique à l'oscillateur radiofréquence 2 à l'exception du fait qu'une couche 44 en matériau antiferromagnétique est déposée sur la couche libre 10. La couche 44 est donc interposée entre d'un côté l'électrode 4 et de l'autre côté la couche libre 10. Par exemple, cette couche 44 est réalisée dans un matériau identique à ceux utilisables pour la couche 16. Cette couche 44 altère la relative liberté de l'aimantation de la couche libre 10. Cependant, en jouant sur l'épaisseur de cette couche 44, on peut faire en sorte que le couplage magnétique mis en oeuvre soit moins important que celui mis en oeuvre entre la couche de référence 8 et la couche antiferromagnétique 16. Ainsi, l'aimantation de la couche libre 10 arrive néanmoins à précesser et le couplage inhérent à la couche antiferromagnétique 44 contribue à maintenir la cohérence de cette aimantation.

La figure 3 représente un oscillateur radiofréquence 50 identique à celui de la figure 2 à l'exception du fait que la couche 44 est remplacée par un polariseur 52 séparé de la couche libre 10 par un espaceur 54. Un polariseur est une couche ou un multicouche magnétique dont l'aimantation est en dehors du plan de la couche et, de préférence, perpendiculaire au plan de la couche. Le polariseur permet de polariser en spin le courant qui le traverse. Typiquement, le polariseur est composé de plusieurs sous-couches superposées les unes sur les autres, par exemple une alternance de couches magnétiques et métalliques (par exemple (Co/Pt)n). Ici, le polariseur n'est pas décrit plus en détail. Pour plus d'informations sur les polariseurs, il est possible de se référer à la demande de brevet FR2 817 998.

Ici, le polariseur 52 est directement déposé sous l'électrode 4. Le moment magnétique de ce polariseur est perpendiculaire au plan des couches.

L'espaceur 54 est directement déposé sous le polariseur 52. Cet espaceur remplit les mêmes fonctions que l'espaceur 12.

La présence du polariseur permet d'obtenir une précession de l'aimantation de la couche libre 10 en dehors de son plan. Cela permet par exemple de faire fonctionner cet oscillateur en champ nul, c'est-à-dire en absence de champ magnétique extérieur.

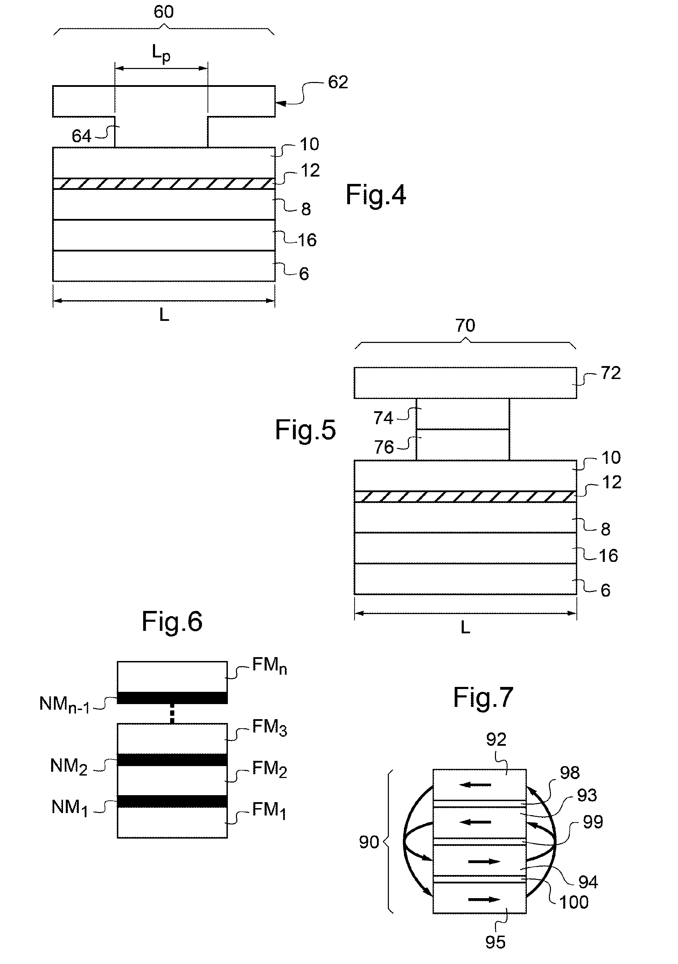

La figure 4 représente un oscillateur radiofréquence 60 dont le facteur de qualité est amélioré en utilisant le même enseignement que celui donné en regard de la figure 1. Toutefois, l'oscillateur 60 est réalisé selon une structure connue sous le terme de nanocontact ou d'empilement « point-contact ». De telles structures sont décrites dans la demande de brevet FR 2 892 871. Elle ne sera donc pas décrite ici en détail.

L'oscillateur 60 est identique à l'oscillateur 2 à l'exception du fait que l'électrode 4 est remplacée par une électrode 62.

L'électrode 6 ainsi que les couches 8, 10, 12 et 16 présentent la même section horizontale de largeur L.

Cette largeur L est typiquement supérieure à 100 nm. Elle peut atteindre plusieurs microns.

L'électrode 62 comporte une pointe 64 de largeur Lp directement en contact avec la face supérieure de la couche libre 10. La largeur Lp est strictement inférieure à la largeur L de sorte que les électrons du courant qui circule entre les électrodes 4 et 6 se répartissent essentiellement dans un cône dans l'empilement des couches 8, 10, 12 et 16. De préférence, la largeur Lp est plusieurs fois inférieure (par exemple cinq fois inférieur) à la largeur L. Par exemple, la largeur Lp est comprise entre quelques nanomètres et 20 nm ou 200 nm.

La figure 5 représente un oscillateur 70 identique à l'oscillateur 60 sauf que l'électrode 62 est remplacée par une électrode 72 superposée sur un polariseur 74 et un espaceur 76. Par exemple, le polariseur 72 et l'espaceur 74 sont identiques, respectivement au polariseur 52 et à l'espaceur 54 sauf que leur largeur Lp est plusieurs fois inférieure à la largeur L des couches 8, 10 et 12. Typiquement, le rapport entre la largeur Lp et la largeur L est identique à celui décrit en regard de la figure 4. Par exemple, leur largeur Lp est identique à celle de la pointe 64.

De nombreux autres modes de réalisation de l'oscillateur radiofréquence sont possibles. Par exemple, les modes de réalisation précédents sont décrits dans le cas particulier où la couche libre est réalisée à l'aide d'un antiferromagnétique synthétique à trois sous-couches ferromagnétiques. Toutefois, il n'est pas nécessaire que les sous-couches ferromagnétiques soit dimensionnées pour que leur moment magnétique se compensent mutuellement. Ainsi, en variante, l'empilement des sous-couches peut simplement former un ferrimagnétique synthétique.

Le ferrimagnétique synthétique peut comporter $n$ sous-couches ferromagnétiques, où $n$ est un entier strictement supérieur à trois. En pratique, $n$ est également inférieur à dix. Ce mode de réalisation d'un ferrimagnétique synthétique à plus de trois sous-couches ferromagnétiques est représenté sur la figure 6 où :

- FM$_i$ désigne la i-ième sous-couche ferromagnétique de l'empilement en partant du bas, et
- NM$_i$ désigne la i-ième sous-couche non magnétique disposée entre les sous-couches ferromagnétiques FM$_i$ et FM$_{i+1}$.

A chaque fois, l'épaisseur de la sous-couche NM$_i$ est apte à créer un couplage RKKY antiférromagnétique entre les sous-couches FM$_i$ et FM$_{i+1}$.

Pour augmenter le volume efficace V$_{eff}$ de la couche libre sans dégrader la cohérence de la précession magnétique, il n'est pas nécessaire que l'empilement de sous-couches ferromagnétiques constitue un ferrimagnétique synthétique. Par exemple, en variante, le ferrimagnétique synthétique décrit précédemment est remplacé par un empilement de sous-couches ferromagnétiques couplées les unes aux autres par un couplage RKKY et dans lequel :

- au moins deux sous-couches ferromagnétiques immédiatement l'une sur l'autre sont couplées par un couplage RKKY ferromagnétique, et
- au moins deux sous-couches ferromagnétiques immédiatement l'une sur l'autre sont couplées par un couplage RKKY antiferromagnétique.

Par « immédiatement l'une sur l'autre », on signifie que les deux sous-couches ferromagnétiques sont uniquement séparées l'une de l'autre par une sous-couche non-magnétique conformée pour créer le couplage RKKY souhaité entre les deux sous-couches ferromagnétiques.

A partir du moment ou l'empilement comprend les deux sous-couches ferromagnétiques couplées par un couplage RKKY ferromagnétique, celui-ci ne constitue plus un « ferrimagnétique synthétique » avec la définition qui en est donné ici.

Par exemple, la figure 7 représente un empilement 90 de quatre sous-couches ferromagnétiques 92 à 95 entre lesquelles sont interposées des sous-couches non magnétiques 98 à 100. L'épaisseur de la sous-couche 98 est choisie pour que les sous-couches 92 et 93 soient couplées magnétiquement par un couplage RKKY ferromagnétique. De façon similaire, l'épaisseur de la sous-couche 100 est choisie pour obtenir un couplage RKKY ferromagnétique entre les sous-couches 94 et 95. Enfin, l'épaisseur de la sous-couche 99 est choisie pour réaliser un couplage RKKY antiferromagnétique entre les sous-couches 93 et 94. Sur la figure 6, la direction du moment magnétique de chaque sous-couche ferromagnétique est représentée par une flèche située dans la sous-couche correspondante. Les flèches recourbées représentées à l'extérieur de l'empilement illustre la direction de quelques lignes de champs magnétiques.

De préférence, l'empilement 90 est compensé, c'est-à-dire qu'il est réalisé de manière à ce que son moment magnétique global soit égal à zéro. Pour cela, il est possible de jouer sur le volume de chaque sous-couche ferromagnétique.

Toutefois pour que le facteur de qualité de l'oscillateur radiofréquence soit amélioré, il n'est pas nécessaire que le ferrimagnétique synthétique ou que l'empilement 90 utilisé soit compensé.

L'amélioration du facteur de qualité de l'oscillateur radiofréquence se produit aussi si la couche de référence est réalisée à l'aide d'un ferrimagnétique synthétique ou d'un empilement d'au moins trois sous-couches ferromagnétiques couplées par couplage RKKY tel que l'empilement 90. Ainsi, en variante, pour améliorer le facteur de qualité, la couche de référence et la couche libre sont toutes les deux réalisées avec un tel empilement. Dans une autre variante, seule l'une de ces deux couches est réalisée par l'un des empilements décrits ci-dessus.

Le polariseur peut être piégé par une couche en matériau antiferromagnétique. Il peut également être compensé pour ne présenter aucune aimantation mesurable en absence de champ magnétique extérieur.

L'ordre d'empilement des différentes couches des oscillateurs décrit en regard des figures 1 à 5 peut être inversé par rapport à l'ordre d'empilement représenté.

Les couches ferromagnétiques ou les sous-couches ferromagnétiques peuvent être laminées comme décrits dans la demande de brevet FR 2 892 871 par exemple dans le passage page 13 lignes 1 à 10. De préférence, seule la sous-couche ferromagnétique la plus proche de la couche formant l'espaceur est laminée.

En variante, la différence de volume entre la première sous-couche la plus proche de l'espaceur et l'une des autres sous-couches est obtenue en diminuant au moins l'une des dimensions horizontales de la première sous-couche.

On peut également introduire dans au moins l'une des sous-couches ferromagnétiques un dopage sous forme d'impuretés à base de terre rare notamment du terbium dans des proportions comprises entre 0,01 % et 2 % (pourcentage atomique) de manière à augmenter la cohérence de la précession.

De façon plus générale, dans tous les modes de réalisation, les sous-couches ferromagnétiques peuvent être remplacées par des sous-couches ferrimagnétiques.

Le matériau ferromagnétique mis en oeuvre dans au moins une des sous-couches ferromagnétique ou ferrimagnétique présente, de préférence, une forte constante de raideur d'échange. A cet effet, on met en oeuvre des matériaux 3d et plus particulièrement, du cobalt ou des alliages riches en cobalt.

Les sous-couches ferromagnétiques ou ferrimagnétiques peuvent également être constituées d'un ensemble de plusieurs lames ferromagnétiques ou ferrimagnétiques directement superposées les unes sur les autres comme par exemple des bicouches de NiFe/CoFe (tous deux ferromagnétiques) ou TbCo/CoFeB (tous deux ferrimagnétiques) communément utilisés dans les vannes de spin.

L'aimantation de la couche de référence peut également être piégée par un champ magnétique extérieur au pilier.

La couche libre peut avoir une aimantation qui précesse dans le plan de la couche ou en dehors du plan de la couche. La direction de plus facile aimantation de la couche libre peut également être en dehors du plan de sa couche et, de préférence, perpendiculaire à son plan.

**Revendications**

**1.** Oscillateur radiofréquence intégrant un dispositif magnétorésistif au sein duquel circule un courant électrique polarisé en spin, ce dispositif comprenant un empilement d'au moins :

- une première couche magnétique (8), dite « couche de référence », apte à polariser en spin le courant électrique et dont l'aimantation est de direction fixe,
- une seconde couche magnétique (10), dite « couche libre », dont l'aimantation peut osciller lorsqu'elle est traversée par le courant polarisé en spin,
- une couche non magnétique (12), dite « espaceur », interposée entre les deux couches précédentes et destinée à découpler magnétiquement lesdites première et seconde couches magnétiques, et
- des moyens (4, 6; 62, 6; 72, 6) pour faire circuler un courant d'électrons dans lesdites couches perpendiculairement à celles-ci,

**caractérisé en ce que** la couche libre (10) et/ou la couche de référence est formée d'un empilement d'au moins trois sous-couches ferromagnétiques (20-22; 92-95) ou ferrimagnétiques entre lesquelles sont interposées des sous-couches conductrices non magnétiques (26, 30; 98-100), ces sous-couches ferromagnétiques ou ferrimagnétiques (20-22; 92-95) étant couplées les unes aux autres par un couplage RKKY (Ruderman-Kittel-Kasuya-Yosida) et parmi lesquelles au moins deux sous-couches ferromagnétiques ou ferrimagnétiques (20-22; 92-95) sont couplées magnétiquement l'une à l'autre par un couplage RKKY antiferromagnétique.

**2.** Oscillateur selon la revendication 1, dans lequel chaque sous-couches ferromagnétique (20-22) ou ferrimagnétique de l'empilement est couplée à la sous-couche ferromagnétique ou ferrimagnétique placée immédiatement au-dessus par un couplage RKKY antiferromagnétique de manière à ce que l'empilement constitue un ferrimagnétique synthétique.

**3.** Oscillateur selon la revendication 2, dans lequel les sous-couches sont des sous-couches ferromagnétiques et les moments magnétiques de chaque sous-couche ferromagnétique (20-22) se compensent mutuellement de manière à ce que l'empilement constitue un antiferromagnetique synthétique.

**4.** Oscillateur selon la revendication 1, dans lequel au moins deux sous-couches ferromagnétiques (93, 94) ou ferrimagnétiques sont couplées l'une à l'autre par un couplage RKKY antiferromagnétique et au moins deux sous-couches ferromagnétiques (92, 93, 94, 95) ou ferrimagnétiques sont couplées l'une à l'autre par un couplage RKKY ferromagnétique.

**5.** Oscillateur selon l'une quelconque des revendications précédentes, dans lequel l'empilement de sous-couches ferromagnétiques (20-22) ou ferrimagnétiques se compose uniquement de trois sous-couches ferromagnétiques ou ferrimagnétiques.

6. Oscillateur selon l'une quelconque des revendications précédentes, dans lequel l'épaisseur d'une première sous-couche ferromagnétique (20) ou ferrimagnétique, la plus proche de la couche non magnétique (12), est inférieure à 10 nm et avantageusement comprise entre 1 et 4 nm.

7. Oscillateur selon l'une quelconque des revendications précédentes, dans lequel au moins la couche libre (10) est formée par l'empilement d'au moins trois sous-couches ferromagnétiques couplées les unes aux autres par un couplage RKKY (Ruderman-Kittel-Kasuya-Yosida).

8. Oscillateur selon la revendication 7, dans lequel l'oscillateur comporte une couche antiferromagnétique (16) directement en contact avec la couche de référence (8) pour piéger son aimantation.

9. Oscillateur selon la revendication 7 ou 8, dans lequel la couche de référence (8) est un antiferromagnétique synthétique.

Fig.1

Fig.2

Fig.3

**Fig.4**

**Fig.5**

**Fig.6**

**Fig.7**

Europäisches
Patentamt

European
Patent Office

Office européen
des brevets

**RAPPORT DE RECHERCHE EUROPEENNE**

Numéro de la demande

EP 10 18 9958

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2005/023938 A1 (SATO RIE [JP] ET AL) 3 février 2005 (2005-02-03) | 1,3,5-7 | INV. H03B9/14 |
| Y | * alinéas [026 ] - [0 49]; figure 1 * ----- | 2 | |
| Y | EP 1 860 769 A1 (JAPAN SCIENCE & TECH AGENCY [JP]) 28 novembre 2007 (2007-11-28) * alinéa [0031]; figure 1a * ----- | 2 | |

| DOMAINES TECHNIQUES RECHERCHES (IPC) |
|---|
| B60N H03B |

Le présent rapport a été établi pour toutes les revendications

| Lieu de la recherche | Date d'achèvement de la recherche | Examinateur |
|---|---|---|
| Munich | 21 janvier 2011 | Schnabel, Florian |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

...........................................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 10 18 9958

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

21-01-2011

| Document brevet cité au rapport de recherche | Date de publication | Membre(s) de la famille de brevet(s) | Date de publication |
|---|---|---|---|
| US 2005023938 A1 | 03-02-2005 | JP 2005025831 A | 27-01-2005 |
| EP 1860769 A1 | 28-11-2007 | JP 2006295908 A<br>WO 2006101040 A1<br>US 2008150643 A1 | 26-10-2006<br>28-09-2006<br>26-06-2008 |

EPO FORM P0460

EP 2 323 252 A1

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 5695864 A
- FR 2892871
- FR 2817998

**Littérature non-brevet citée dans la description**

- **Baibich, M. ; Broto, J.M. ; Fert, A. ; Nguyen Van Dau, F. ; Petroff, F. ; Etienne, P. ; Creuzet, G. ; Friederch, A. ; Chazelas, J.** Giant magnetoresistance of (001)Fe/(001)Cr magnetic superlattices. *Phys.Rev.Lett.,* 1988, vol. 61, 2472
- **Moodera, JS. ; Kinder, LR. ; Wong, TM. ; Meservey,R.** Large magnetoresistance at room temperature in ferromagnetic thin film tunnel junctions. *Phys.Rev.Lett,* 1995, vol. 74, 3273-6
- **Katine, J.A. ; Albert, F.J. ; Buhrman, R.A. ; Myers, E.B. ; Ralph, D.C.** Current-Driven Magnetization Reversal and Spin-Wave Excitations in Co /Cu /Co Pillars. *Phys.Rev.Lett.,* 2000, vol. 84, 3149
- **Kiselev, S.I. ; Sankey, J.C. ; Krivorotov, LN. ; Emley, N.C. ; Schoelkopf, R.J. ; Buhrman, R.A. ; Ralph, D.C.** Microwave oscillations of a nanomagnet driven by a spin-polarized current. *Nature,* 2003, vol. 425, 380
- **S. Parkin et al.** *Physical Review B,* 1991, vol. 44 (13
- **S. Parkin et al.** *Physical Review Letters,* 1990, vol. 64 (19

14